Europäisches Patentamt

European Patent Office

Office européen des brevets

(19)

(11) Publication number: **0 061 343**
**B1**

# (12) EUROPEAN PATENT SPECIFICATION

(45) Date of publication of patent specification: **04.12.85**

(51) Int. Cl.⁴: **H 02 H 9/04,** H 02 H 7/127

(21) Application number: **82301493.1**

(22) Date of filing: **23.03.82**

(54) **An arrester device for protecting a thyristor valve arrangement from overvoltage.**

(30) Priority: **24.03.81 JP 41784/81**

(43) Date of publication of application:
**29.09.82 Bulletin 82/39**

(45) Publication of the grant of the patent:
**04.12.85 Bulletin 85/49**

(84) Designated Contracting States:
**CH DE FR GB LI SE**

(56) References cited:
**DE-A-1 538 155**
**DE-B-2 137 129**
**DE-B-2 303 279**
**DE-B-2 434 279**
**GB-A-1 204 838**
**US-A-3 947 726**

**CIGRE Paper 14-03 (1978)**

(73) Proprietor: **Kabushiki Kaisha Toshiba**
**72, Horikawa-cho Saiwai-ku**
**Kawasaki-shi Kanagawa-ken 210 (JP)**

(72) Inventor: **Kobayashi, Sumio**
**263, Shishigaya Tsurumi-ku**
**Yokohama-shi Kanagawa-ken (JP)**

(74) Representative: **Kirk, Geoffrey Thomas et al**
**BATCHELLOR, KIRK & EYLES 2 Pear Tree Court**
**Farringdon Road**
**London EC1R 0DS (GB)**

Courier Press, Leamington Spa, England.

**Description**

This invention relates to an arrester device for protecting a thyristor valve arrangement from overvoltage.

A high voltage conversion device, which consists of a plurality of thyristors connected in series, has been used in a DC transmission system. In such a system, protection of the thyristors against overvoltage is a very important problem.

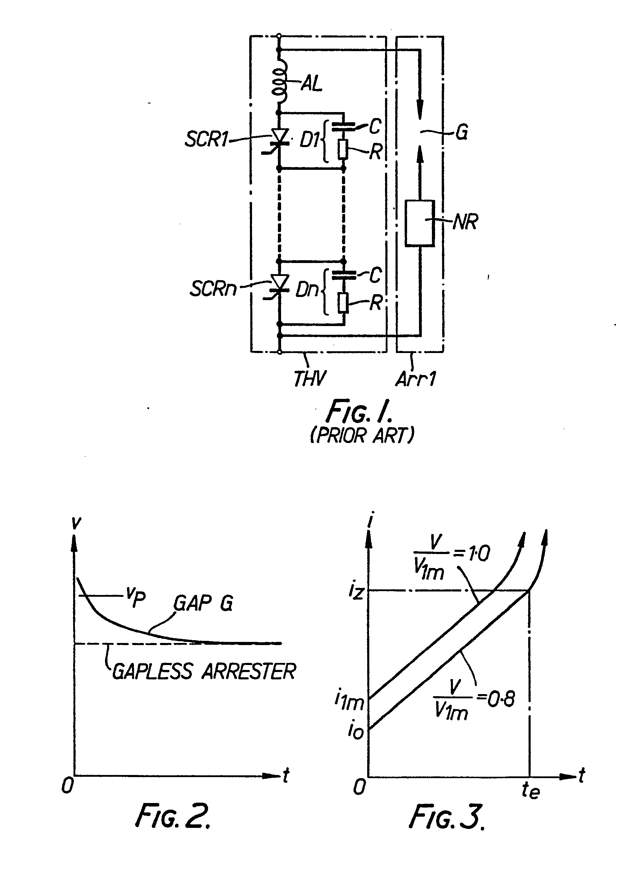

At the International Conference on Large High Voltage Electric Systems held from 30th August to 7th September, 1978, a report entitled "Testing of Thyristor Valves for Bipole 2 of the Manitoba HVDC System" was delivered (Cigre Paper 14.03 1978). Figure 2 of the report discloses a thyristor valve arrangement protected by an arrester device employing a spark-over gap.

This arrangement is shown schematically in Figure 1 of the accompanying drawings. Reference character THV designates the thyristor valve arrangement to be protected, which consists of a series circuit of thyristors $SCR_1$ to $SCR_n$ and an anode reactor AL. Voltage dividers $D_1$ to $D_n$ are connected in parallel with the thyristors and a gate pulse generator is not shown. Each of the voltage dividers $D_1$ to $D_n$ includes a series connected circuit of a capacitor C and a resistor R. The thyristor valve THV is protected from overvoltage by an arrester $Arr_1$ which comprises a series connected air gap G and a non-linear resistance element NR, electrical discharge is arranged to occur at the gap G when a voltage appearing across the gap G exceeds a predetermined level, and any overvoltage energy is thus absorbed by the non-linear resistance element NR so as to protect the thyristor valve THV.

In such a conventional device, as shown in Figure 1, a protection level against an overvoltage applied thereto is determined in accordance with the characteristics of the arrester $Arr_1$. More particularly, the protection level varies depending on various conditions, such as the discharge condition at the gap G, the non-linear characteristic of the non-linear resistance element NR, and the like. According to the above factors, the number of thyristors $SCR_1$ to $SCR_n$ which are to be connected in series in the thyristor valve THV is determined.

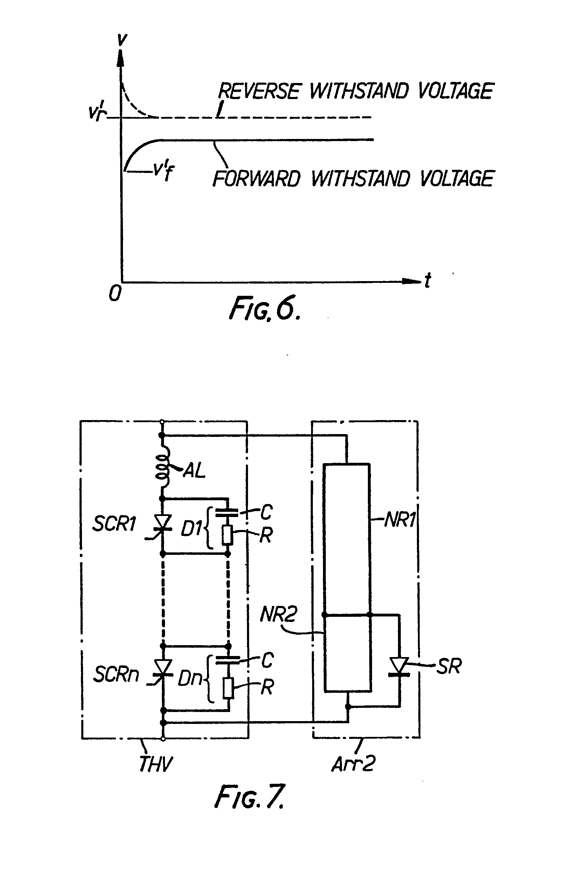

Figure 2 indicates the v—t characteristic curve of an arrester, wherein v is a spark-over voltage of the arrester, t is a period of time during which the voltage v is applied to the arrester and Vp is a protection level. In Figure 2, the spark-over characteristics at the gap G exhibit a tendency that the spark-over voltage v increases in response to a voltage abruptly applied to the gap G. On the other hand, withstand voltages of the thyristors $SCR_1$ to $SCR_n$ decrease with respect to a forward voltage abruptly applied thereto, as shown in Figure 6, wherein v is the withstand voltage of a thyristor and t is a period of time during which the withstand voltage v is applied to the thyristor. Consequently, the protection level of the conventional arrester $Arr_1$ is generally set at a protection level Vp which is obtained taking the abruptly level Vp which is obtained taking the abruptly changing voltage into consideration, as shown in Figure 2.

That is, as is apparent from Figure 2, the protection level of an arrester with a discharge gap becomes higher. Therefore, the conventional protection system in which such an arrester is employed to protect a thyristor valve is disadvantageous in that the necessary number of thyristors increases, with the result that it is not economical.

An object of this invention is to provide an arrester for protecting a thyristor valve arrangement which can bring about a reduction in the number of thyristors connected in series in the thyristor valve arrangement.

According to a first aspect of the present invention, there is provided an arrester device for protecting a thyristor valve arrangement, comprising a plurality of thyristors connected electrically in series, from overvoltage, said device being arranged for connection electrically in parallel with the thyristor valve arrangement and comprising a first non-linear resistance element, characterised by the provision of a second non-linear element connected in series with the first element and by-pass circuit means connected in parallel with the second element and arranged to short circuit said second element only when a voltage of predetermined polarity is applied to said second element.

According to a second aspect of the invention, there is provided a circuit arrangement comprising a thyristor valve arrangement comprising a plurality of thyristors connected electrically in series and an arrester device for protecting the valve arrangement from overvoltage, said device being connected in parallel with the thyristor valve arrangement and comprising at least one arrester comprising a first non-linear resistance element and characterised by the provision of a second non-linear resistance element connected in series with the first element and by-pass circuit means connected in parallel with the second element and arranged to short circuit said second element only when a voltage having a polarity in the forward direction of the thyristor valve is applied to said second element.

A more complete appreciation of the invention and many of the attendant advantages thereof will be readily obtained as the same becomes better understood by reference to the following detailed description when considered in connection with the accompanying drawings, wherein:—

Figure 1 is a schematic diagram showing a conventional overvoltage protection device for a thyristor valve;

Figure 2 is a graphical representation showing a v-t characteristic curve of an arrester;

Figure 3 is a graphical representation showing a life time characteristic of a non-linear resistor element;

Figure 4 is a graphical representation showing a v-i characteristic curve of a non-linear resistor element;

Figure 5 is a graphical representation showing the voltage waveform of a thyristor valve;

Figure 6 is a graphical representation showing a withstand voltage characteristic in forward and reverse directions for a thyristor valve;

Figure 7 is a schematic diagram showing one preferred embodiment of the present invention, and

Figures 8, 9, 10, 11 and 12 are schematic diagrams showing other embodiments of the present invention.

As stated previously, in an arrester with an air gap, the spark-over characteristic tends to increase with the abruptness of the application of voltage. On the other hand, in an arrester without a gap, the spark-over characteristic can be made flat, as shown in Figure 2. The protection level could be reduced by the use of a gapless arrester instead of the arrester $Arr_1$ with the gap G in Figure 1. In this case, many problems have arisen as described below and, therefore, such a protection system has not been put into practical use.

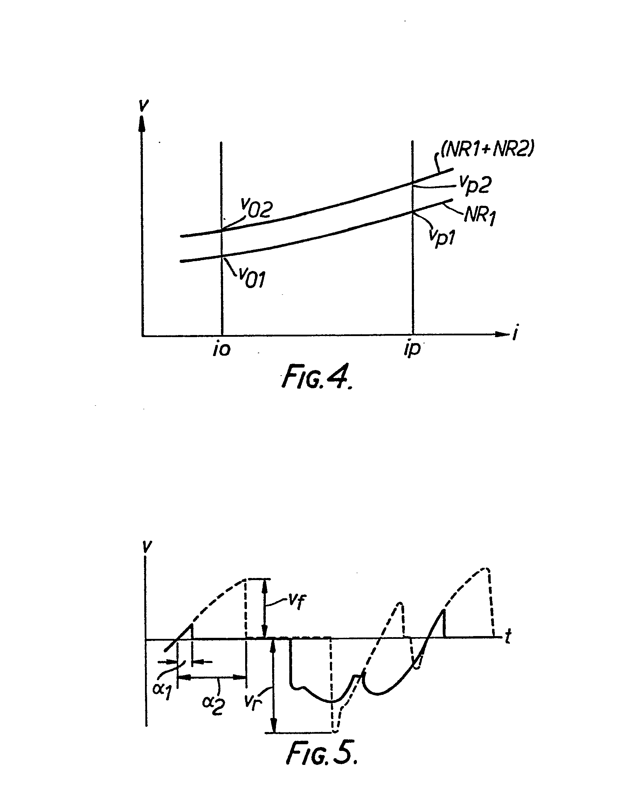

(1) When employing a gapless arrester, even when an ordinary voltage is applied to the thyristor valve, a leakage current flows through the non-linear resistance element, resulting in deterioration of the resistance element. More specifically, the life time of the non-linear resistance element is shortened. Figure 3 is a graphical representation showing the relation between a period of time t, during which a voltage is applied to the non-linear resistance element, and the leakage current i. An applied voltage ratio, defined by a value which is obtained by dividing a voltage V applied to the non-linear resistance element by a voltage $V_{1m}$ appearing across the non-linear resistance element when a current of 1 mA flows therethrough, is regarded as a parameter. As is clear from Figure 3, if the leakage current exceeds a certain current level iz, it abruptly increases. As a result, the non-linear resistance element is likely to break down. On the other hand, as the applied voltage ratio increases, the life time is shortened. In Figure 3, $i_0$ and $i_{1m}$ are leakage currents at t=0 when the coefficients $V/V_{1m}$ are 0.8 and 1.0, respectively. Accordingly, it is required to inhibit the leakage current from exceeding a desired current level $i_0$ when taking the life time of equipment into account.

(2) In order to suppress the leakage current flowing through the non-linear resistance element, it is necessary to increase the resistance value of the non-linear resistance element. As a result, the protection level of the arrester, when an overvoltage is applied, also increases. Figure 4 is a graphical representation showing the v-i characteristic curve of a non-linear resistance element where the resistance value thereof is regarded as a parameter. Assuming that reference character $i_0$ indicates a maximum allowable leakage current value and reference character $i_p$ indicates a current value when an applied voltage exceeds an allowable voltage range, a continuous allowable applied voltage and a protection level of a non-linear resistance element $NR_1$ are represented by reference characters $v_{01}$ and $v_{p1}$, respectively. On the contrary, a continuous allowable applied voltage and a protection level of series connected non-linear resistance elements $NR_1+NR_2$ are represented by reference characters $v_{02}$ and $v_{p2}$, respectively. They are higher than those of the resistance element $NR_1$.

In attempting to find a solution of the two problems described above, it was found that the difference in the withstand voltages of a thyristor in the forward and reverse directions presented a great difficulty. This difficulty will be explained hereinafter with reference to Figures 5 and 6. Taking the differences in the withstand voltages of a thyristor into consideration, the present invention has been able to solve the problems in leakage current described previously. Under the invention, the number of thyristors connected in series in a thyristor valve is reduced while maintaining appropriate protection level.

Referring now to Figure 7 of the drawings, a gapless arrester $Arr_2$ includes series connected non-linear resistance elements $NR_1$ and $NR_2$, and a by-pass circuit SR composed of one diode or series connected diodes which is connected in parallel with the non-linear resistance element $NR_2$. The arrester $Arr_2$ is used as a protection device for the thyristor valve THV.

Non-linear resistance element $NR_1$ and $NR_2$ are formed, for example, of a sintered material including zinc oxide as a major component. In the gapless arrester $Arr_2$, the by-pass circuit SR is provided to operate as a short circuit for the non-linear resistance element $NR_2$ when an overvoltage in a forward direction is applied to the thyristor valve THV, whereby a protection level in the forward direction is selectively reduced. While a leakage current i with respect to an ordinary applied voltage is inhibited from exceeding an allowable current range $i_0$, the protection level with respect to the overvoltage in the forward direction is represented by $v_{p1}$, shown in Figure 4, whereas the protection level with respect to that in the reverse direction is represented by $v_{p2}$ in Figure 4. Therefore, it is possible to obtain a gapless arrester $Arr_2$ whose protection levels are different in the forward and reverse directions; that is, a gapless arrester $Arr_2$ in which the protection level in the forward direction is lower than that in the reverse direction. As described above, since the withstand voltage of the thyristor in the forward direction is lower than that in the reverse direction, when the gapless arrester $Arr_2$ is used to protect the thyristors $SCR_1$ to $SCR_n$, the necessary number of thyristors $SCR_1$ to $SCR_n$, which are contained in the thyristor valve THV, can br reduced.

As an example, where the thyristor valve THV is driven as a three-phase bridge circuit (not shown), the waveform of a voltage, which is usually applied to the thyristor valve THV, varies in accordance with a controlling angle $\alpha$ of the thyristors and is asymmetrical in the forward and reverse directions, as shown in Figure 5. In Figure 5, two waveforms corresponding to two controlling angles $\alpha_1$ and $\alpha_2$ are shown. In the case of the controlling angle $\alpha$ being approximately $\alpha_2$ (=90°), as indicated by a dotted line in Figure 5, the voltages in the forward and reverse directions exhibit maximum values, respectively. Therefore, a value of the leakage current i flowing through the gapless arrester $Arr_2$, which is connected in parallel to the thyristor valve THV, has to be determined taking the above fact into account. In the case, the maximum voltage value in the forward direction is equal to the value $v_f$ of an AC voltage applied to the thyristor valve. The maximum voltage $v_r$ in the reverse direction, however, increases to a value 1.3 to 1.35 times as much as the maximum value $v_f$ due to a transient overshoot (referred to as a commutation overshoot) which occurs when the thyristor is turned off.

Assuming that a gapless arrester without a by-pass circuit, i.e. an arrester which is not in accordance with the invention, is employed to protect the thyristor valve, the necessary number of thyristors to be connected in series in the thyristor valve can be determined, as follows. Where a maximum allowable value of the leakage current flowing through the arrester, with the maximum voltage $v_r$ across the thyristor valve, is determined as the current value $i_0$ shown in Figure 4, the maximum voltage $v_r$ is equal to the continuous allowable applied voltage $v_{02}$, and the protection level of the arrester, when the excess current $i_p$ flows, is thus equal to the protection level $v_{p2}$. Since the overvoltage has polarities in both forward and reverse directions, and further the withstand voltage of the thyristor in the forward direction is lower than that in the reverse direction, as shown in Figure 6, the necessary number n of thyristors connected in series should be obtained based on the voltage $v_{f'}$ in the forward direction. Accordingly, the necessary number n of series connected thyristors is expressed as follows:—

$$n = \frac{v_{p2} \times k}{v_{f'}} \qquad (1)$$

where $v_{f'}$ is the withstand voltage of a thyristor in a forward direction shown in Figure 6 and k is a voltage unbalance factor among series connected thyristors.

In contrast, in the embodiment according to this invention shown in Figure 7, the gapless arrester $Arr_2$ with the by-pass circuit SR is used for protecting thyristors $SCR_1$ to $SCR_n$ in the thyristor valve THV. Generally, the ratio $v_r/v_f$ of voltage in the reverse and forward directions, which are usually applied to the thyristor valve, is equal to between 1.3 and 1.35. Thus, in order to adjust the leakage current with the voltage $v_f$ in the forward direction to the allowable current value $i_0$ of the

arrester $Arr_2$, it is considered that the voltage $v_f$ in the forward direction is set to the continuous allowable applied voltage $v_{01}$, whereas the voltage $v_r$ in the reverse direction is set to the voltage $v_{02}$. In this case, a protection level in the forward direction is defined by $v_{p1}$, whereas that in the reverse direction is defined by $v_{p2}$. Therefore, $v_{p2}/v_{p1} \approx 1.3$ to 1.35. Accordingly, the necessary number of thyristors is determined so as to meet the protection level $v_{p1}$ in the forward direction and $v_{p2}$ in the reverse direction.

The necessary number $n_f$ of the thyristors, which is obtained with respect to the protection level $v_{p1}$ in the forward direction, is expressed as follows:

$$n_f = \frac{v_{p1} \times k}{v_{f'}}$$

The necessary number $n_r$ of the thyristors, which is obtained with respect to the protection level $v_{p2}$ in the reverse direction, is expressed as follows:

$$n_r = \frac{v_{p2} \times k}{v_{r'}}$$

where $v_{r'}$ is a withstand voltage of the thyristor in the reverse direction. It is ideal to design a thyristor valve so as to meet the condition of $n_f = n_r$. In this case the following expression is obtained:

$$n_f = n_r = \frac{v_{p1} \times k}{v_{f'}} = \frac{v_{p2} \times k}{v_{r'}} \qquad (2)$$

From the expression (2),

$$\frac{v_{p2}}{v_{p1}} \approx \frac{v_{r'}}{v_{f'}} \approx 1.3 \text{ to } 1.35 \qquad (3)$$

That is, it is an optimum condition that the ratio of the withstand voltage in the reverse direction and that in the forward direction is adjusted within the range of 1.3 to 1.35. In this case, the necessary number of the thyristors can be remarkably reduced to 1/1.3 to 1/1.35 when compared with the number of thyristors defined by the expression (1).

As the protection level is approximately proportional to the resistance value of the non-linear resistance element, it is an optimum condition that the ratio of the resistance value of the non-linear resistance element $(NR_1 + NR_2)$ and that of the non-linear resistance element $NR_1$ is within the range of 1.3 to 1.35.

$$\left( \frac{NR_1 + NR_2}{NR_1} \approx 1.3 \sim 1.35 \right)$$

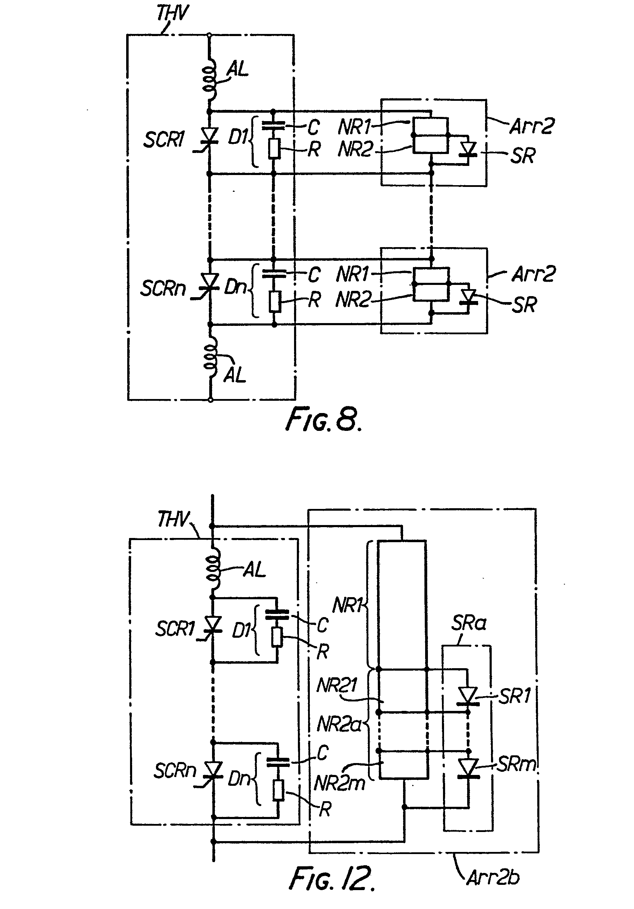

The present invention has been described hereinbefore with reference to an embodiment in which an arrester is connected in parallel across a thyristor valve including series connected thyristors. It goes without saying that the same effects can be obtained by providing a plurality of gapless arresters $Arr_2$ according to this invention, each arrester $Arr_2$ being connected in parallel with a corresponding one thyristor $SCR_1 \sim SCR_n$, as shown in Figure 8.

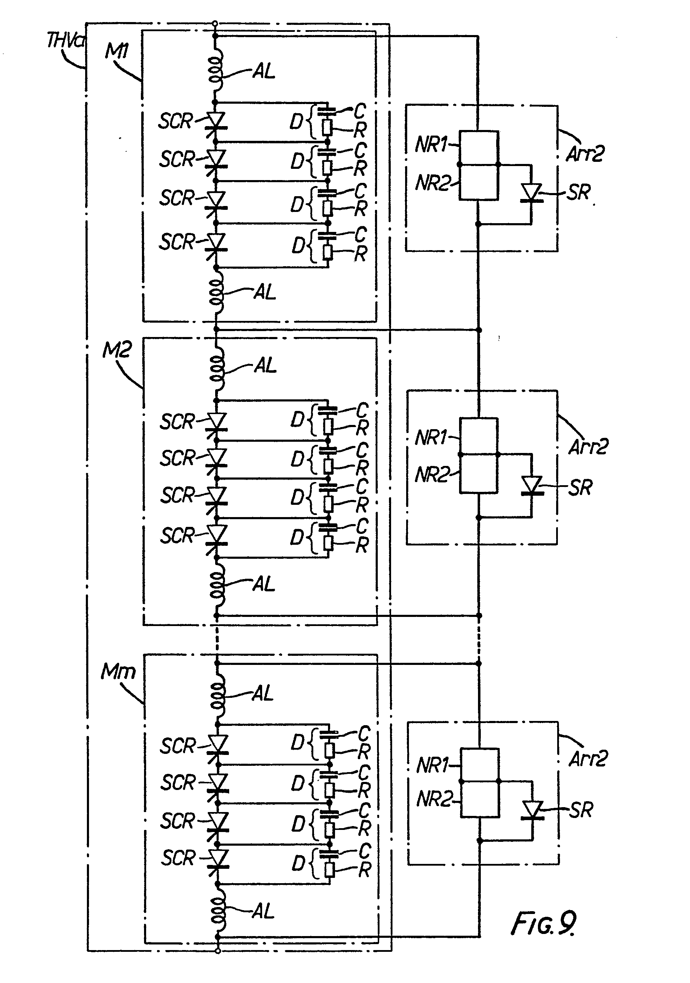

Further, when a thyristor valve $THV_a$ includes a plurality of series connected module $M_1 \sim M_m$, each module $M_1 \sim M_m$ having series connected thyristors SCR and reactors AL, and voltage dividers D, the same effects can be obtained by providing a plurality of arresters $Arr_2$ according to this invention, each arrester $Arr_2$ being connected in parallel with the corresponding one module, $M_1 \sim M_m$, as shown in Figure 9.

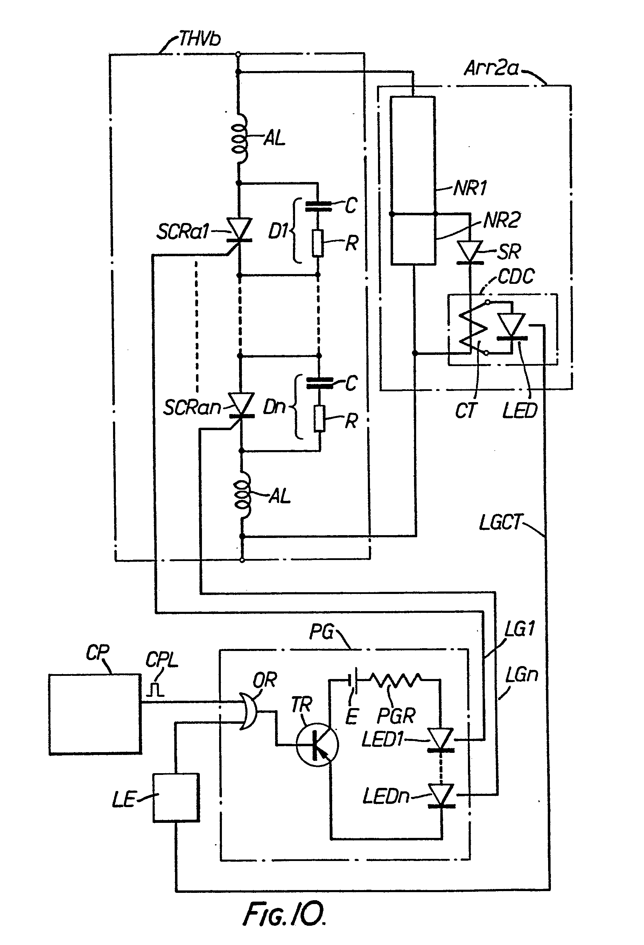

Figure 10 shows another embodiment of this invention. In Figure 10, reference character $Arr_{2a}$ designates an arrester according to another embodiment of this invention, which includes the series connected non-linear resistance elements $NR_1$ and $NR_2$ and the bypass circuit SR connected in parallel with the non-linear resistance element $NR_2$. The arrester $Arr_{2a}$ further includes a current detection circuit CDC connected in series with the by-pass circuit SR. The current detection circuit CDC includes a current transformer CT which detects a current flowing through the by-pass circuit SR and a light emitting diode LED. The light emitting diode LED is connected in series with the current transformer CT and produces a light signal based on the detected current flowing through the light emitting diode LED.

Reference character $THV_b$ designates a thyristor valve to be protected by the arrester $Arr_{2a}$, which is composed of a series circuit of photo thyristors $SCR_{a1}$ to $SCR_{an}$, the voltage dividers $D_1$ to $D_n$, the anode reactors AL. Reference character CP designates a control panel and produces a timing pulse CPL which is applied to a gate pulse generator PG. The timing pulse CPL is then applied to a transistor TR through an OR gate OR to be amplified. As a result of this, a current flows through a resistor PGR, light emitting diodes $LED_1$ to $LED_n$ and the transistor TR from a power source E. The light signals produced by the light emitting diodes $LED_1$ to $LED_n$ are transmitted to the gate terminals of the photo thyristors $SCR_1$ to $SCR_n$ through optical fibres $LG_1$ to $LG_n$, respectively. The light signal of the light emitting diode LED in the current detection circuit CDC is applied to a light-electricity converter LE through an optical fibre LGCT. The applied light signal is converted into an electric signal in the light-electricity converter LE and then applied to the transistor TR through the OR gate OR. As a result of this, the light signals are also produced at the light emitting diodes $LED_1$ to $LED_n$ and are transmitted to the gate terminals of the photo thyristors $SCR_1$ to $SCR_n$ to thereby trigger all the photo thyristors $SCR_1$ to $SCR_n$ simultaneously.

In this embodiment, when it is necessary to reduce the protection level in the forward direction sharply, it may be possible to detect the current flowing through the by-pass circuit SR, drive the gate pulse generator PG for the thyristor valve $THV_b$ in response to the thus detected current and then forcibly trigger all of the photo thyristors $SCR_{a1}$ to $SCR_{an}$ connected in series simultaneously, to thereby prevent break-down and component damage.

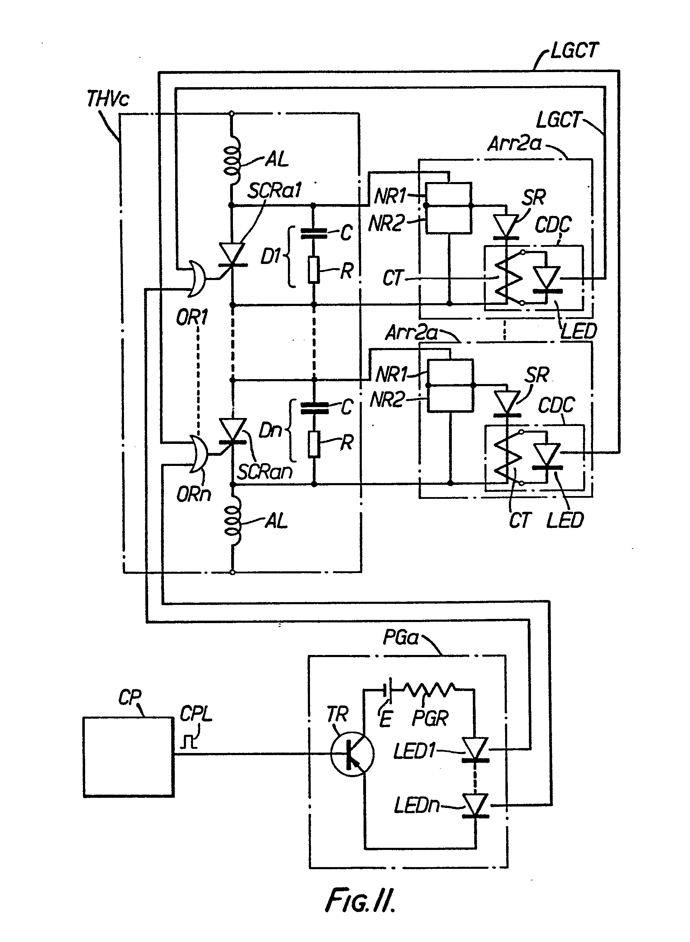

In a critical turn off condition, it sometimes occurs that some of the series connected thyristors in the thyristor valve are turned off and others remain in the on state. In this case, an overvoltage may be applied to the turned off thyristors in the forward direction and they may be destroyed. In order to avoid this, still another embodiment of this invention, shown in Figure 11, is provided. In Figure 11, reference character $THV_c$ designates a thyristor valve which has the same construction as the thyristor valve $THV_b$ shown in Figure 10 except that there are further provided OR gates $OR_1$ to $OR_n$ for the photo thyristors $SCR_{a1}$ to $SCR_{an}$, respectively. A gate pulse generator $PG_a$ is provided instead of the gate pulse generator PG shown in Figure 10. The gate pulse generator $PG_a$ has the same construction as the gate pulse generator PG except that, firstly, the OR gate OR is omitted and, secondly, the light signal from the arrester $Arr_{2a}$ is not applied to the gate pulse generator $PG_a$. The gate pulse generator $PG_a$ receives the timing pulse CPL from the control panel CP and produces light signals at the light emitting diodes $LED_1$ to $LED_n$. Each of the arresters $Arr_{2a}$ is connected in parallel with each of the photo thyristors $SCR_{a1}$ to $SCR_{an}$. Each of the light signals of the light emitting diodes LED of the arresters $Arr_{2a}$ is applied to each of one input terminals of the OR gates $OR_1$ to $OR_n$. Each of the light signals of the light emitting diodes $LED_1$ to $LED_n$ of the gate pulse generator $PG_a$ is applied to each of the other input terminals of the OR gates $OR_1$ to $OR_n$. Each of the output terminals of the OR gates $OR_1$ to $OR_n$ is connected to each of the gate terminals of the photo thyristors $SCR_{a1}$ to $SCR_{an}$. Each of the photo thyristors $SCR_{a1}$ to $SCR_{an}$ can be triggered by the light signals from each of the light emitting diodes $LED_1$ to $LED_n$ or the light signal from the light emitting diode LED of the corresponding arrester $Arr_{2a}$.

When an overvoltage in the forward direction is applied to the turned off photo thyristors $SCR_{a1}$ to $SCR_{an}$, the current flowing through the by-pass circuit SR of the corresponding gapless arrester $Arr_{2a}$ is detected and the detected current is used to trigger the corresponding turned off photo thyristors $SCR_{a1}$ to $SCR_{an}$, to thereby protect the photo thyristors $SCR_{a1}$ to $SCR_{an}$ from an overvoltage in the forward direction.

Figure 12 shows an arrester $Arr_{2b}$ according to another embodiment of this invention. The arrester $Arr_{2b}$ includes series connected non-linear resistance element $NR_1$ and $NR_{2a}$ and a by-pass circuit $SR_a$ connected in parallel with the non-linear resistance elements $NR_{2a}$. The by-pass

circuit SR$_a$ includes a plurality of series connected diodes SR$_1$ to SR$_m$ and the non-linear resistance elements NR$_{2a}$ is divided into a plurality of series connected non-linear resistance element portions NR$_{21}$ to NR$_{2m}$. Each of the diodes SR$_1$ to SR$_m$ is connected in parallel with the corresponding one non-linear resistance element portion NR$_{21}$ to NR$_{2m}$. In this embodiment, non-linear resistance portions NR$_{21}$ to NR$_{2m}$ necessary to be by-passed may serve as voltage dividing elements of the series connected diodes SR$_1$ to SR$_m$.

In this specification, when describing the invention and in the claims, the term thyristor is employed. This term is intended to include a thyristor in the conventional sense, a photo thyristor and a gate turn-off thyristor.

The present invention permits the required number of thyristors connected in series in the valve arrangement to be remarkably reduced, as a result of which, the provision of an economical and reliable thyristor valve arrangement becomes possible.

Obviously, numerous modifications and variations of the present invention are possible in light of the above teachings. It is, therefore, to be understood that, within the scope of the appended claims, the invention may be practiced otherwise than as specifically described herein.

**Claims**

1. An arrester device (Arr$_2$) for protecting a thyristor valve arrangement (THV), comprising a plurality of thyristors (SCR$_1$—SCR$_n$) connected electrically in series, from overvoltage, said device (Arr$_2$) being arranged for connection electrically in parallel with the thyristor valve arrangement (THV) and comprising a first non-linear resistance element (NR1), characterised by the provision of a second non-linear element (NR2) connected in series with the first element (NR1) and by-pass circuit means (SR) connected in parallel with the second element (NR2) and arranged to short circuit said second element only when a voltage of predetermined polarity is applied to said second element (NR2).

2. An arrester device as claimed in claim 1, characterised in that said by-pass circuit means (SR) includes at least one diode.

3. An arrester device as claimed in claim 1, characterised in that said by-pass circuit means (SR$_a$) includes a series circuit of a plurality of diodes (SR$_1$—SR$_m$) and said second non-linear resistance element (NR$_{2a}$) includes a series connection of a like plurality of non-linear resistance elements (NR$_{21}$—NR$_{2m}$), and each of said diodes (SR$_1$—SR$_m$) is connected in parallel with a corresponding one of said non-linear resistance elements (NR$_{21}$—NR$_{2m}$) (Fig. 12).

4. An arrester device as claimed in any preceding claim, characterised in that the resistance value of said second non-linear resistance element (NR$_2$) is about 35% of the resistance value of said first non-linear resistance element (NR$_1$).

5. An arrester device as claimed in any preceding claim, characterised in that said first (NR$_1$) and second (NR$_2$) non-linear resistance elements are mainly of zinc oxide.

6. An arrester device as claimed in any preceding claim and characterised by the provision of current detection means (CDC) connected to detect a current flowing through said by-pass circuit means (SR) and for producing a signal based on said detected current (Fig. 10, 11).

7. An arrester device as claimed in claim 6, characterised in that said current detection means (CDC) includes a current transformer (CT) connected to detect the current flowing through said by-pass circuit means (SR), and a light emitting diode (LED) connected to said current transformer (CT) for producing a light signal as said signal based on said detected current (Fig. 10, 11).

8. A circuit arrangement comprising a thyristor valve arrangement (THV) comprising a plurality of thyristors (SCR$_1$—SCR$_n$) connected electrically in series and an arrester device (Arr$_2$) for protecting the valve arrangement (THV) from overvoltage, said device (Arr$_2$) being connected in parallel with the thyristor valve arrangement (THV) and comprising at least one arrester (Arr$_2$) comprising a first non-linear resistance element (NR1) and characterised by the provision of a second non-linear resistance element (NR2) connected in series with the first element (NR1) and by-pass circuit means (SR) connected in parallel with the second element (NR2) and arranged to short circuit said second element (NR2) only when a voltage having a polarity in the forward direction of the thyristor valve (THV) is applied to said second element (NR2).

9. A circuit arrangement as claimed in claim 8, characterised in that said thyristor valve arrangement (THV) includes a series circuit of a plurality of thyristors (SCR$_1$—SCR$_n$) and a reactor (AL), said arrester device includes a series circuit of a like plurality of said arresters (Arr$_2$) and each of said arresters is connected in parallel with a respective one of said corresponding thyristors (SCR$_1$—SCR$_n$) (Fig. 8, 11).

10. A circuit arrangement as claimed in claim 8, characterised in that the thyristors are arranged in modules (M$_1$—M$_m$) with each module comprising a plurality of thyristors (SCR) and the arrester device comprises a series circuit of a like plurality of arresters (Arr$_2$), with each module having a respective one of the arresters connected in parallel therewith (Fig. 9).

11. A circuit arrangement as claimed in claim 8, characterised by the further provision of gate pulse generator means (PG) for controlling said thyristors (SCR$_{a1}$—SCR$_{an}$) and wherein said arrester (Arr$_{2a}$) further includes current detection means (CDC) connected to detect a current flowing through said by-pass circuit means (SR) for producing a signal based on said detected current, and said gate pulse generator means (PG) is further connected to said arrester (Arr$_{2a}$)

for receiving said signal and for controlling said thyristors ($SCR_{a1}$—$SCR_{an}$) based on said signal (Fig. 10).

12. A circuit arrangement as claimed in claim 8, characterised by the further provision of gate pulse generator means ($PG_a$) for controlling said thyristor ($SCR_{a1}$—$SCR_{an}$) wherein said arrester device includes a series circuit of a like plurality of said arresters ($Arr_{2a}$), each of said arresters ($Arr_{2a}$) being connected in parallel with each said corresponding thyristor, each of said arresters ($Arr_{2a}$ further includes current detection means (CDC) connected to detect a current flowing through said bypass circuit means (SR) for producing a signal based on said detected current, and each of said thyristors ($SCR_{a1}$—$SCR_{an}$) is further connected to its corresponding current detection means (CDC) for receiving said signal which serves to control the operation of the thyristor in conjunction with said pulse generator means ($PG_a$) (Fig. 11).

13. A circuit arrangement as claimed in any of the claims 8 to 12, characterised in that said thyristors are photo thyristors.

14. A circuit arrangement as claimed in any of the claims 8 to 12, characterised in that said thyristors are gate turn-off thyristors.

## Patentansprüche

1. Überspannungsschutz für eine aus mehreren in Reihe geschalteten Thyristoren ($SCR_1$ bis $SCR_n$) bestehende Thyristorschaltung (THV), wobei ein Überspannungs-Ableitsystem ($Arr_2$) zur Thyristorschaltung (THV) parallel geschaltet ist und aus einem ersten nicht linearen Widerstand (NR1) besteht, dadurch gekennzeichnet, daß ein zweiter nicht linearer Widerstand (NR2) vorgesehen ist, der zum Widerstand (NR1) in Reihe geschaltet ist, und daß zum Widerstand (NR2) ein Überbrückungskreis (SR) parallel geschaltet ist, der den Widerstand (NR2) kurzschließt, wenn ihm eine Spannung mit vorbestimmter Polarität aufgeschaltet wird.

2. Überspannungsschutz nach Anspruch 1, dadurch gekennzeichnet, daß der Überbrückungskreis (SR) mindestens eine Diode aufweist.

3. Überspannungsschutz nach Anspruch 1, dadurch gekennzeichnet, daß zum Überbrückungskreis ($SR_a$) eine aus mehreren Dioden ($SR_1$ bis $SR_n$) bestehende Reihenschaltung gehört, und daß der zweite nicht lineare Widerstand ($NR_{2a}$) aus gleich vielen nicht linearen Widerstandselemente ($NR_{21}$ bis $NR_{2n}$) besteht, wobei je eine der Dioden ($SR_1$ bis $SR_n$) zu den ihr jeweils zugeordneten nicht linearen Widerstandselement ($NR_{21}$ bis $NR_{2n}$) parallel geschaltet ist (Fig. 12).

4. Überspannungsschutz nach mindestens einem der Ansprüche 1 bis 2, dadurch gekennzeichnet, daß der Widerstandswert des Widerstandes ($NR_2$) 35% des Widerstandswerts des Widerstandes ($NR_1$) beträgt.

5. Überspannungsschutz nach mindestens einem der Ansprüche 1 bis 4, dadurch gekennzeichnet, daß der Widerstand ($NR_1$) und der Widerstand ($NR_2$) vorwiegend aus Zinkoxyd bestehen.

6. Überspannungsschutz nach mindestens einem der Ansprüche 1 bis 5, dadurch gekennzeichnet, daß eine Stromdetektorschaltung (CDC) vorgesehen ist, die den im Überbrückungskreis (SR) fließenden Strom erfaßt und aufgrund des erfaßten Stroms ein Signal erzeugt (Fig. 10, 11).

7. Überspannungsschutz nach Anspruch 6, dadurch gekennzeichnet, daß die Stromdetektorschaltung (CDC) einen Stromwandler (CT) aufweist, der derart angeordnet ist, daß er den im Überbrückungskreis (SR) fließenden Strom erfaßt, und daß eine Leuchtdiode (LED), die mit dem Stromwandler (CT) verbunden ist, aufgrund des erfaßten Stroms ein Lichtsignal erzeugt (Fig. 10, 11).

8. Überspannungsschutz mit einer aus mehreren in Reihe geschalteten Thyristoren ($SCR_1$ bis $SCR_n$) bestehenden Thyristorschaltung (THV) und einem Überspannungsableitsystem ($Arr_2$), das der Thyristorschaltung (THV) parallel geschaltet ist und mindestens einen nicht linearen Widerstand ($NR_1$) aufweist, dadurch gekennzeichnet, daß ein zweiter nicht linearer Widerstand ($NR_2$) mit dem Widerstand ($NR_1$) in Reihe geschaltet ist, und daß zum Widerstand (NR2) ein Überbrückungskreis (SR) parallel geschaltet ist, der den Widerstand (NR2) dann kurz schließt, wenn ihm eine Spannung mit einer der Thyristorschaltung-Durchlaßrichtung entsprechenden Polarität aufgeschaltet wird.

9. Überspannungsschutz nach Anspruch 8, dadurch gekennzeichnet, daß die Thyristorschaltung (THV) aus mehreren in Reihe geschalteten Thyristoren ($SCR_1$ bis $SCR_n$) und aus einer Drossel (AL) besteht, und daß zum Überspannungsableitsystem ($Arr_2$) Überspannungsableiter gehören und das je ein Überspannungsableiter einem Thyristor ($SCR_1$ bis $SCR_n$) parallel geschaltet ist (Fig. 8, 11).

10. Überspannungsschutz nach Anspruch 8, dadurch gekennzeichnet, daß die Thyristoren in Modulen ($M_1$ bis $M_n$) angeordnet sind, die jeweils mehrere Thyristoren (SCR) aufweisen, und daß das Überspannungsableitsystem ($ARR_2$) aus einer Reihenschaltung von Überspannungsableitern besteht, wobei jedem Modul ein bestimmter Überspannungsableiter parallel geschaltet ist (Fig. 9).

11. Überspannungsschutz nach Anspruch 8, dadurch gekennzeichnet, daß zum Ansteuern der Thyristoren ($SCR_{a1}$ bis $SCR_{an}$) ein Koinzidenz-Impulsgenerator (PG) vorgesehen ist, daß das Überspannungsableitsystem ($Arr_2$) eine Stromdetektorschaltung (CDC) aufweist, welche den im Überbrückungskreis (SR) fließenden Strom erfaßt und im Ansprechen auf diesen Strom ein Signal erzeugt, und daß der Impulsgenerator (PG) derart mit dem Überspannungsableitsystem ($Arr_2$) verbunden ist, daß er das Signal aufnehmen und anhand dieses Signals regelnd auf die Thyristoren (SCR$_{a1}$ bis SCR$_{an}$) einwirken kann (Fig. 10).

12. Überspannungsschutz nach Anspruch 8, dadurch gekennzeichnet, daß zum regelnden Einwirken auf die Thyristoren (SCR$_{a1}$ bis SCR$_{an}$) ein Koinzidenz-Impulsgenerator (PG$_a$) vorgesehen ist, daß das Überspannungsableitsystem (Arr$_2$) aus einer Reihenschaltung von Überspannungsableitern (Arr$_{2a}$) besteht, wobei je einer der Überspannungsableiter einem der Thyristoren parallel geschaltet ist, daß jeder der Überspannungsableiter (Arr$_{2a}$) eine Stromdetektorschaltung (CDC) aufweist, die den durch den Überbrückungskreis (SR) fließenden Strom erfaßt und im Ansprechen auf diesen Strom ein Signal erzeugt und daß die Thyristoren (SCR$_{a1}$ bis SCR$_{an}$) jeweils derart mit den ihnen zeugeordneten Stromdetektorschaltungen (CDC) verbunden sind, daß sie deren Signale zusammen mit dem vom Impulsgenerator (PG$_a$) der aufgeschalteten Impulse aufnehmen können (Fig. 11).

13. Überspannungsschutz nach mindestens einem der Ansprüche 8 bis 12, dadurch gekennzeichnet, daß es sich bei den Thyristoren um Fototthyristoren handelt.

14. Überspannungsschutz nach mindestens einem der Ansprüche 8 bis 12, dadurch gekennzeichnet, daß es sich bei den Thyristoren um GTO-Thyristoren handelt.

## Revendications

1. Une structure de parafoudre (Arr$_2$) destinée à protéger contre les surtensions un redresseur à thyristors (THV) comprenant un ensemble de thyristors (SCR$_1$—SCR$_n$) connectés électriquement en série, cette structure (Arr$_2$) étant conçues pour être connectée électriquement en parallèle avec le redresseur à thyristors (THV) et comprenant un premier élément à résistance non linéaire (NR1), caractérisée par l'existence d'un second élément non linéaire (NR2) connecté en série avec le premier élément (NR1), et d'un circuit de dérivation (SR) connecté en parallèle avec le second élément (NR2) et conçu de façon à court-circuiter le second élément uniquement lorsqu'une tension de polarité prédéterminée est appliquée à ce second élément (NR2).

2. Une structure de parafoudre selon la revendication 1, caractérisée en ce que le circuit de dérivation (SR) comprend au moins une diode.

3. Une structure de parafoudre selon la revendication 1, caractérisée en ce que le circuit de dérivation (SR$_a$) comprend un circuit série formé par un ensemble de diodes (SR$_1$—SR$_m$), et le second élément à résistance non linéaire (NR$_{2a}$) comprend une connexion en série d'un ensemble similaire d'éléments à résistance non linéaire (NR$_{21}$—NR$_{2m}$), et chacune des diodes (SR$_1$—SR$_m$) est connectée en parallèle avec l'un correspondant des éléments à résistance non linéaire (NR$_{21}$—NR$_{2m}$) (Fig. 12).

4. Une structure de parafoudre selon l'une quelconque des revendications précédentes, caractérisée en ce que la valeur de résistance du second élément à résistance non linéaire (NR$_2$) est égale à environ 35% de la valeur de résistance du premier élément à résistance non linéaire (NR$_1$).

5. Une structure de parafoudre selon l'une quelconque des revendications précédentes, caractérisée en ce les premier (NR$_1$) et second (NR$_2$) éléments à résistance non linéaire consistent essentiellement en oxyde de zine.

6. Une structure de parafoudre selon l'une quelconque des revendications précédentes, et caractérisée par l'existence de moyens de détection de courant (CDC) connectés de façon à détecter un courant traversant le circuit de dérivation (SR), et à produire un signal basé sur ce courant détecté (Figures 10, 11).

7. Une structure de parafoudre selon la revendication 6, caractérisé en ce que les moyens de détection de courant (CDC) comprennent un transformateur d'intensité (CT) qui est connecté de façon à détecter le courant qui circule dans le circuit de dérivation (SR), et une diode électroluminescente (LED) connectée au transformateur d'intensité (CT), pour produire un signal lumineux en tant que signal basé sur le courant détecté (Figures 10, 11).

8. Un circuit comprenant un redresseur à thristors (THV) qui comporte plusieurs thyristors (SCR$_1$—SCR$_n$) connectés électriquement en série, et une structure de parafoudre (Arr$_2$) destinée à protéger le redresseur (THV) contre une surtension, cette structure de parafoudre (Arr$_2$) étant connectée en parallèle avec le redresseur à thyristors (THV) et comprenant au moins un parafoudre (Arr$_2$) qui comprend un premier élément à résistance non linéaire (NR1), et caractérisé par l'existence d'un second élément à résistance non linéaire (NR2) connecté en série avec le premier élément (NR1) et d'un circuit de dérivation (SR) connecté en parallèle avec le second élément (NR2) et conçu de façon à court-circuiter ce second élément (NR2) seulement lorsqu'une tension ayant une polarité correspondant au sens direct du redresseur à thyristors (THV) est appliquée au second élément (NR2).

9. Un circuit selon la revendication 8, caractérisé en ce que le redresseur à thyristors (THV) comprend un circuit série formé par un ensemble de thyristors (SCR$_1$—SCR$_n$) et une réactance (AL), et la structure de parafoudre comprend un circuit série formé par un ensemble similaire de parafoudres (Arr$_2$), et chacun de ces parafoudres est connecté en parallèle avec l'un respectif des thyristors correspondants (SCR$_1$—SCR$_n$) (Figures 8, 11).

10. Un circuit selon la revendication 8, caractérisé en ce que les thyristors sont disposés en modules (M$_1$—M$_m$), chaque module comprenant un ensemble de thyristors (SCR), et la structure de parafoudre comprend un circuit série formé par un ensemble similaire de parafoudres (Arr$_2$), avec l'un respectif des parafoudres connecté en parallèle sur chaque module (Figure 9).

11. Un circuit selon la revendication 8, caractérisé en ce qu'il comprend en outre un générateur d'impulsions de gâchette (PG) destiné à commander les thyristors ($SCR_{a1}$—$SCR_{an}$), et en ce que le parafoudre ($Arr_{2a}$) comprend en outre des moyens de détection de courant (CDC) connectés de façon à détecter un courant qui traverse le circuit de dérivation (SR), pour produire un signal basé sur le courant détecté, et le générateur d'impulsions de gâchette (PG) est en outre connecté au parafoudre ($Arr_{2a}$) pour recevoir ce signal et pour commander les thyristors ($SCR_{a1}$—$SCR_{an}$) sur la bse de ce signal (Figure 10).

12. Un circuit selon la revendication 8, caractérisé en ce qu'il comprend en outre un générateur d'impulsions de gâchette ($PG_a$) destiné à commander les thyristors ($SCR_{a1}$—$SCR_{an}$), et en ce que la structure de parafoudre comprend un circuit série formé par un ensemble similaire de parafoudres ($Arr_{2a}$), chacun de ces parafoudres ($Arr_{2a}$) étant connecté en parallèle avec chaque thyristor correspondant, chacun des parafoudres ($Arr_{2a}$) comprend en outre des moyens de détection de courant (CDC) qui sont connectés de façon à détecter un courant traversant le circuit de dérivation (SR), pour produire un signal basé sur ce courant détecté, et chacun des thyristors ($SCR_{a1}$—$SCR_{an}$) est en outre connecté à ces moyens de détection de courant correspondants (CDC), pour recevoir ledit signal qui a pour fonction de commander le fonctionnement du thyristor en association avec le générateur d'impulsions ($PG_a$) (Figure 11).

13. Un circuit selon l'une quelconque des revendications 8 à 12, caractérisé en ce que les thyristors sont des photothyristors.

14. Un circuit selon l'une quelconque des revendications 8 à 12, caractérisé en ce que les thyristors sont des thyristors à blocage par la gâchette.

0 061 343

FIG. 1.
(PRIOR ART)

FIG. 2.

FIG. 3.

1

FIG.4.

FIG.5.

FIG. 6.

FIG. 7.

Fig.8.

Fig. 12.

4

**Fig. 9.**

0 061 343

FIG. 10.

FIG.II.